# EUROPÄISCHE PATENTSCHRIFT

(11) **EP 2 345 076 B1**
(45) Veröffentlichungstag und Bekanntmachung des Hinweises auf die Patenterteilung: **01.08.2018**
(21) Anmeldenummer: 09796598.2
(22) Anmeldetag: 15.10.2009
(51) Int. Cl.: H01L 23/498, H01L 23/31

(54) **OBERFLÄCHENMONTIERBARE VORRICHTUNG**
SURFACE-MOUNTABLE APPARATUS
DISPOSITIF POUVANT ÊTRE MONTÉ EN SURFACE

(30) Priorität: 13.11.2008 DE 102008057174
(43) Veröffentlichungstag der Anmeldung: 20.07.2011
(73) Patentinhaber: OSRAM Opto Semiconductors GmbH, 93055 Regensburg (DE)
(72) Erfinder: KUHLMANN, Werner, 81541 München (DE); SCHUMANN, Michael, 89231 Neu-Ulm (DE); HOEFER, Thomas, 93138 Lappersdorf (DE)
(74) Vertreter: Epping - Hermann - Fischer
(86) Internationale Anmeldenummer: PCT/DE2009/001435
(87) Internationale Veröffentlichungsnummer: WO 2010/054613

(56) Entgegenhaltungen:
- EP-A1- 1 919 000
- WO-A2-2006/005062
- GB-A- 2 098 002
- US-A1- 2004 188 696
- US-B1- 6 531 328
- US-B1- 6 890 796

## Beschreibung

Diese Patentanmeldung beansprucht die Priorität der deutschen Patentanmeldung 10 2008 057 174.1. Die vorliegende Erfindung betrifft eine oberflächenmontierbare Vorrichtung mit einer Montageseite, einer der Montageseite gegenüberliegenden Oberseite, einer elektrisch isolierenden Trägerplatte, einem elektrischen Bauelement und einem Gehäuse. Die WO 2006/005062 beschreibt bekannte oberflächenmontierbare gehäuste lichtemittierende Bauelemente. Herkömmlicherweise weisen oberflächenmontierbare Vorrichtungen eine Trägerplatte, ein darauf angeordnetes elektrisches Bauelement und ein Gehäuse auf, das beispielsweise aus einer Moldmasse besteht. Die Kontaktierung des elektrischen Bauelements erfolgt bisher meist mittels eines Bonddrahtes, der von einer Oberseite des Bauelements zu der Trägerplatte geführt ist, und durch einen Leitkleber an einer Unterseite des Bauelements. Dabei ist üblicherweise die Grundfläche des Gehäuses kleiner als die Grundfläche der Trägerplatte. Die Trägerplatte ragt somit an zwei gegenüberliegenden Seiten über das Gehäuse hinaus, um in Bereichen der überstehenden Trägerplatte elektrische Führungen, beispielsweise Leiterbahnen, auf eine Montageseite der Trägerplatte zu führen, die dem Gehäuse gegenüberliegend angeordnet ist. Eine so ausgebildete Vorrichtung mit einer dem Gehäuse überragenden Trägerplatte führt jedoch nachteilig zu einem erhöhten Platzverbrauch.

Der Erfindung liegt die Aufgabe zugrunde, eine oberflächenmontierbare Vorrichtung anzugeben, die besonders Platz sparend ist, insbesondere eine geringe Vorrichtungsgröße und eine geringe laterale Ausdehnung aufweist.

Diese Aufgabe wird durch eine oberflächenmontierbare Vorrichtung mit den Merkmalen des Patentanspruchs 1 gelöst. Vorteilhafte Ausführungsformen und bevorzugte Weiterbildungen der oberflächenmontierbaren Vorrichtung sind Gegenstand der abhängigen Ansprüche.

Erfindungsgemäß ist eine oberflächenmontierbare Vorrichtung vorgesehen, die eine Montageseite, eine der Montageseite gegenüberliegende Oberseite, eine elektrisch isolierende Trägerplatte, ein elektrisches Bauelement und ein Gehäuse aufweist. Die Trägerplatte schließt die Vorrichtung zur Montageseite hin ab und weist eine der Montageseite gegenüberliegende Befestigungsseite auf, auf der zur elektrischen Kontaktierung des Bauelements Leiterbahnen angeordnet sind. Auf der Montageseite der Trägerplatte sind Kontaktflächen angeordnet. Ferner weist die Trägerplatte Durchbrüche auf, wobei jeweils eine Kontaktfläche mittels eines Durchbruchs mit einer Leiterbahn elektrisch leitend verbunden ist. Das Bauelement ist auf der Befestigungsseite der Trägerplatte angeordnet und von dem Gehäuse umschlossen. Zumindest ein Durchbruch in der Trägerplatte ist unterhalb des Bauelements angeordnet. Das Gehäuse ist auf der Befestigungsseite der Trägerplatte angeordnet und schließt die Vorrichtung zur Oberseite hin ab. Das Gehäuse und die Trägerplatte sind in Draufsicht auf die Trägerplatte bündig zueinander angeordnet.

Elektrische Führungen, beispielsweise Leiterbahnen, von der Befestigungsseite der Trägerplatte zu der Montageseite der Trägerplatte werden somit über Durchbrüche, so genannte Mikrovias, geführt. Diese werden vorzugsweise unterhalb des Bauelements angeordnet. Dadurch sind überstehende Trägerplattenbereiche, die zur Führung der Leiterbahnen auf die Montageseite der Trägerplatte dienen, mit Vorteil nicht notwendig. Die Vorrichtungsgröße, insbesondere die laterale Ausdehnung der Vorrichtung und die Grundfläche der Vorrichtung, kann so mit Vorteil reduziert werden. Dies ist insbesondere für Vorrichtungen, die vergleichsweise große Bauelemente umfassen, und/oder für Vorrichtungen, die eine gewisse Komplexität, insbesondere eine Mehrzahl von externen elektrischen Anschlussstellen aufweisen, vorteilhaft.

Die Vorrichtung kann vorzugsweise mit der Montageseite auf einer Leiterplatte angeordnet sein, wobei die Kontaktflächen der Vorrichtung bevorzugt mit Anschlussstellen der Leiterplatte elektrisch leitend verbunden sind, beispielsweise mittels eines Leitklebers. Die elektrische Kontaktierung des elektrischen Bauelements der Vorrichtung führt somit von den Anschlussstellen der Leiterplatte über die Kontaktflächen und die Durchbrüche der Trägerplatte zu den Leiterbahnen auf der Befestigungsseite der Trägerplatte.

Bei einer bevorzugten Ausgestaltung der oberflächenmontierbaren Vorrichtung sind die Durchbrüche der Trägerplatte ausschließlich unterhalb des Bauelements angeordnet.

Dadurch verkleinert sich mit Vorteil weiter die Vorrichtungsgröße, insbesondere die laterale Ausdehnung der Vorrichtung. Eine Platz sparende oberflächenmontierbare Vorrichtung ist mit Vorteil möglich.

Bei einer weiteren bevorzugten Ausgestaltung der oberflächenmontierbaren Vorrichtung isoliert das Gehäuse das Bauelement und die Leiterbahnen nach außen hin vollständig elektrisch.

Mit Vorteil können so externe elektrische Führungen, beispielsweise elektrische Führungen von benachbarten elektrischen Bauelementen, auf dem Gehäuse oder an Seitenflächen des Gehäuses angeordnet werden, ohne dabei einen Kurzschluss der Vorrichtung, insbesondere des elektrischen Bauelements der Vorrichtung, zu erzeugen. Platz sparende Anordnungen umfassend eine Mehrzahl von elektrischen Vorrichtungen oder Bauelementen sind so mit Vorteil möglich.

Das Gehäuse ist bevorzugt aus einem Material, das elektrisch isolierend ist. Besonders bevorzugt weist das Gehäuse eine Moldmasse auf.

Bei einer weiteren bevorzugten Ausgestaltung der Vorrichtung ist die Vorrichtung ausschließlich über die Montageseite nach außen elektrisch leitend kontaktierbar.

Insbesondere ist die Vorrichtung vorzugsweise ausschließlich mittels der Durchbrüche elektrisch leitend kontaktierbar.

Dadurch, dass die Vorrichtung ausschließlich über die Montageseite mittels der Durchbrüche elektrisch leitend kontaktierbar ist, und die Oberseite der Vorrichtung, insbesondere das Gehäuse der Vorrichtung elektrisch isolierend ausgebildet ist, kann die Gefahr eines Kurzschlusses der Vorrichtung, insbesondere des elektrischen Bauelements, mit Vorteil minimiert werden.

Besonders bevorzugt weist die Vorrichtung Seitenflächen auf, wobei die Seitenflächen und die Oberseite der Vorrichtung nach außen hin vollständig elektrisch isolierend ausgebildet sind.

Insbesondere weist die Vorrichtung keine elektrischen Führungen auf, insbesondere Leiterbahnen und/oder Bonddrähte, die bis zu den Seitenflächen der Vorrichtung reichen und dort nach außen hin elektrisch kontaktierbar sind. Mit Vorteil bieten so die Seitenflächen und/oder die Oberseite der Vorrichtung die Möglichkeit, für beispielsweise externe elektrische Führungen von beispielsweise benachbarten elektrischen Bauelementen zur Verfügung zu stehen. Vorrichtungsnahe Anordnungen externer elektrischer Bauelemente ermöglichen sich so mit Vorteil, wodurch sich Platz sparende Anordnungen multipler elektrischer Bauelemente oder Vorrichtungen realisieren lassen. Erfindungsgemäß ist zwischen dem Bauelement und der Trägerplatte eine elektrisch isolierende Trennschicht angeordnet.

Insbesondere sind bevorzugt auf der Befestigungsseite der Trägerplatte angeordnete Leiterbahnen ganz oder teilweise mit der elektrisch isolierenden Trennschicht bedeckt. Dadurch wird eine elektrische Isolierung zwischen dem Bauelement und den Leiterbahnen im Bereich der Befestigung des Bauelements erzielt.

Bevorzugt ist das elektrische Bauelement an einer Oberseite, die von der Trägerplatte abgewandt ist, elektrisch leitend mit den Leiterbahnen verbunden, insbesondere mittels Bonddrähten. Insbesondere führt jeweils ein Bonddraht von der Oberseite des Bauelements zu jeweils einer Leiterbahn der Trägerplatte. In diesem Fall erfolgt die elektrische Kontaktierung des Bauelements somit lediglich von der Oberseite des Bauelements. Andere einseitige elektrische Kontaktierungen eines elektrischen Bauelements und damit verbundene elektrische Führungen in dem elektrischen Bauelement, wie beispielsweise Flip-Chip-Bauelemente, sind dem Fachmann bekannt und werden daher an dieser Stelle nicht näher erläutert. Erfindungsgemäß ist das Bauelement auf einem Durchbruch der Trägerplatte angeordnet und durch den Durchbruch mit einer Kontaktfläche elektrisch leitend verbunden. So ist eine zweiseitige Kontaktierung des elektrischen Bauelements möglich. Eine elektrische Kontaktierung wird an einer Unterseite des Bauelements über den Durchbruch zu der Kontaktfläche geführt. Die zweite elektrische Kontaktierung des Bauelements kann dagegen von der Oberseite des Bauelements mittels eines Bonddrahtes zu jeweils einer Leiterbahn geführt sein. Erfindungsgemäß ist in der Trennschicht eine Öffnung angeordnet, die insbesondere ein elektrisch leitendes Material enthält und die Unterseite des Bauelements mit dem Durchbruch der Trägerplatte, und damit der Kontaktfläche, elektrisch leitend verbindet. Erfindungsgemäß ist das Bauelement mittels eines Klebers, eines Leitklebers oder eines elektrisch leitenden Lotes befestigt. Erfindungsgemäß weist das Bauelement eine zur Erzeugung oder zur Detektion von elektromagnetischer Strahlung geeignete aktive Schicht auf. Die aktive Schicht des Bauelements weist bevorzugt mindestens einen pn-Übergang, eine Doppelheterostruktur, eine Einfachquantentopfstruktur (SQW, single quantum well) oder eine Mehrfachquantentopfstruktur (MQW, multi quantum well) zur Strahlungserzeugung auf. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen. Besonders bevorzugt weist das Bauelement eine der Trägerplatte gegenüberliegende Strahlungsaustrittsseite auf, durch die im Bauelement erzeugte Strahlung das Bauelement verlassen kann. Bevorzugt ist die Oberseite des Bauelements die Strahlungsaustrittsseite.

Bevorzugt ist das Bauelement ein Halbleiterkörper, besonders bevorzugt ein Dünnfilmhalbleiterkörper. Als Dünnfilmhalbleiterkörper wird im Rahmen der Anmeldung ein Halbleiterkörper angesehen, während dessen Herstellung das Aufwachssubstrat, auf den eine Halbleiterschichtenfolge, die einen Halbleiterkörper des Dünnfilmhalbleiterkörpers umfasst, beispielsweise epitaktisch aufgewachsen wurde, abgelöst worden ist.

Die Schichten des Halbleiterkörpers basieren bevorzugt auf einem III/V-Verbindungshalbleitermaterial. Ein III/V-Verbindungshalbleitermaterial weist wenigstens ein Element aus der dritten Hauptgruppe, wie beispielsweise Al, Ga, In und ein Element aus der fünften Hauptgruppe, wie beispielsweise N, P, As auf. Insbesondere umfasst der Begriff III/V-Verbindungshalbleitermaterial die Gruppe der binären, ternären und quaternären Verbindungen, die wenigstens ein Element aus der dritten Hauptgruppe und wenigstens ein Element aus der fünften Hauptgruppe enthalten, insbesondere Nitrid- und Phosphidverbindungshalbleiter. Eine solche binäre, ternäre oder quaternäre Verbindung kann zudem beispielsweise einen oder mehrere Dotierstoffe sowie zusätzliche Bestandteile aufweisen.

Besonders bevorzugt ist das Bauelement eine LED, eine IRED, ein Fototransistor, eine Fotodiode oder ein Opto-IC.

Ist das Bauelement im Wesentlichen zur Detektion von Strahlung vorgesehen, beispielsweise als Fotodiode, Fototransistor oder Opto-IC ausgebildet, so enthalten die Schichten des Bauelements bevorzugt Silizium.

Vorzugsweise ist das Gehäuse für die von dem Bauelement emittierte oder zu detektierende Strahlung transparent. Die von dem Bauelement erzeugte oder zu detektierende Strahlung kann so durch das Gehäuse ausgekoppelt werden. Insbesondere weist das Gehäuse für die von dem Bauelement emittierte oder zu detektierende Strahlung einen niedrigen Absorptionskoeffizient auf.

Alternativ kann das Gehäuse für Strahlung in einem Wellenlängenbereich strahlungsundurchlässig sein. In diesem Fall dient das Gehäuse zur Wellenlängenselektion. Strahlung in einem bestimmten, insbesondere unerwünschten, Wellenlängenbereich kann so aus dem Wellenlängenbereich der von dem Bauelement emittierten oder zu detektierenden Strahlung selektiv herausgefiltert werden. Das Gehäuse dient so als Filter für bestimmte Wellenlängen.

Bei einer bevorzugten Ausgestaltung der Vorrichtung ist eine Mehrzahl elektrischer Bauelemente auf der Befestigungsseite der Trägerplatte angeordnet, die jeweils von dem Gehäuse vollständig umschlossen sind.

Mit Vorteil können so während eines Herstellungsverfahrens eine Mehrzahl von Vorrichtungen erzeugt werden. Eine Massenproduktion oberflächenmontierbarer Vorrichtungen ermöglicht sich mit Vorteil.

Insbesondere wird so eine Mehrzahl von Vorrichtungen hergestellt, die anschließend mittels Vereinzelung, beispielsweise durch Sägen in zwei Richtungen, voneinander getrennt werden. In diesem Fall werden alle vier Seitenflächen der Vorrichtung durch Sägen erzeugt. Alternativ kann zur Vereinzelung lediglich in eine Richtung gesägt werden, so dass lediglich zwei Seitenflächen der Vorrichtung durch Sägen erzeugt werden.

Insbesondere sind für die Vorrichtung Trägerplatten, die lediglich eine Schicht aufweisen, und Trägerplatten, die einen mehrschichtigen Aufbau aufweisen, denkbar. Bei einer bevorzugten Ausgestaltung der Vorrichtung weist die Trägerplatte einen mehrschichtigen Aufbau auf. Durch einen mehrschichtigen Aufbau können Eigenschaften der Trägerplatte an erwünschte Anforderungen angepasst sein. Beispielsweise zeichnet sich eine mehrschichtige Trägerplatte durch eine verbesserte Kriechstromfestigkeit, verbesserte Hochfrequenzeigenschaften oder eine geringer Wasseraufnahme aus.

Vorzugsweise enthält die Trägerplatte ein Grundmaterial, beispielsweise eine Keramik oder Epoxidharz, und ein darin enthaltenes Glasfasergewebe. Insbesondere ist die Trägerplatte bevorzugt elektrisch isolierend.

Bei einer bevorzugten Ausgestaltung weisen die Durchbrüche der Trägerplatte jeweils ein elektrisch leitendes Material auf. Dabei können die Durchbrüche teilweise oder vollständig mit dem elektrisch leitenden Material gefüllt sein. Das elektrisch leitende Material ist beispielsweise ein Metall oder eine Metalllegierung.

Bevorzugt enthalten die Durchbrüche der Trägerplatte einen elektrisch leitenden Vollkörper, der bevorzugt in die Durchbrüche eingesteckt ist. Bevorzugt ist der Vollkörper dabei an die Größe des Durchbruchs derart angepasst, dass er diesen nach dem Einstecken vollständig ausfüllt. Beispielsweise kann der Vollkörper Kupfer enthalten oder aus Kupfer bestehen.

Als weitere Variante ist denkbar, dass die Durchbrüche mit einem elektrisch isolierenden Material gefüllt und/oder mit einem elektrisch isolierenden Material abgedeckt sind. Insbesondere können die Durchbrüche mittels der elektrisch isolierenden Trennschicht, die zwischen Bauelement und Trägerplatte angeordnet ist, abgedeckt sein.

Die Durchbrüche der Trägerplatte können demnach anwendungsspezifisch ausgestaltet sein. Insbesondere können die Durchbrüche je nach Anwendungsbereich eine elektrisch leitende Füllmasse, eine elektrisch isolierende Füllmasse und/oder Luft enthalten.

Weitere Merkmale, Vorteile, bevorzugte Ausgestaltungen und Zweckmäßigkeiten der oberflächenmontierbaren Vorrichtung ergeben sich aus dem im Folgenden in Verbindung mit den Figuren 1 bis 5 erläuterten Ausführungsbeispielen.

Es zeigen:
- Figur 1: eine schematische Ansicht eines Ausführungsbeispiels einer erfindungsgemäßen Vorrichtung,
- Figuren 2A bis 2C: jeweils eine schematische Ansicht einer erfindungsgemäßen Vorrichtung in verschiedenen Herstellungsstadien,
- Figur 3A bis 3C: jeweils einen Längsschnitt eines weiteren Ausführungsbeispiels einer erfindungsgemäßen Vorrichtung,
- Figur 4: einen schematischen Querschnitt eines weiteren Ausführungsbeispiels einer erfindungsgemäßen Vorrichtung, und
- Figur 5A, 5B: jeweils eine Ansicht eines Ausführungsbeispiels einer herkömmlichen oberflächenmontierbaren Vorrichtung.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

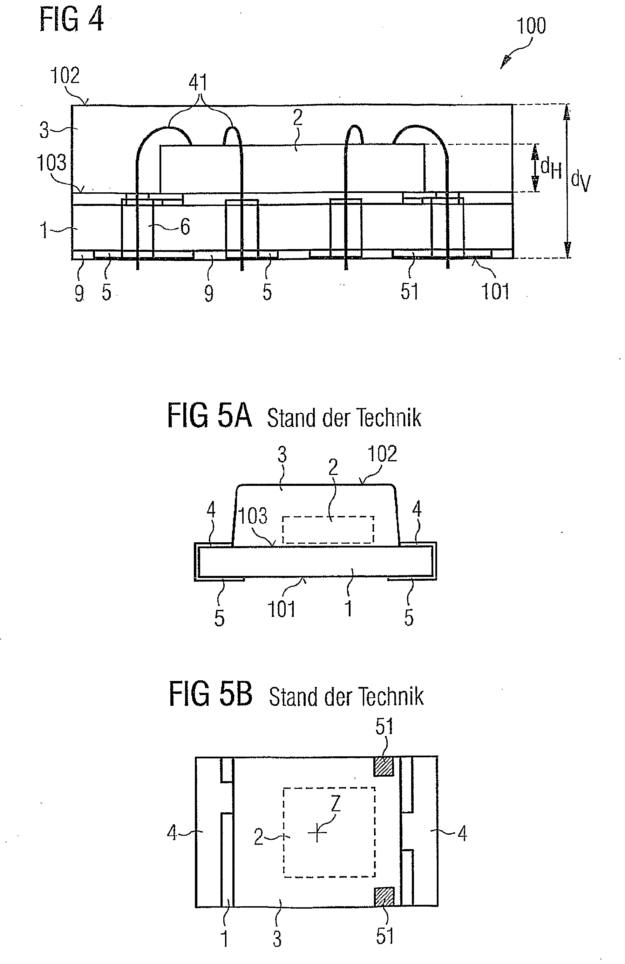

In den Figuren 5A und 5B ist jeweils eine herkömmliche oberflächenmontierbare Vorrichtung dargestellt. Insbesondere ist in Figur 5A ein Querschnitt einer herkömmlichen Vorrichtung und in 5B eine Aufsicht auf die Vorrichtung des Ausführungsbeispiels der Figur 5A dargestellt. Die Vorrichtung weist eine Montageseite 101, eine der Montageseite 101 gegenüberliegende Oberseite 102, eine Trägerplatte 1, ein elektrisches Bauelement 2 und ein Gehäuse 3 auf.

Das elektrische Bauelement 2 ist insbesondere auf der Trägerplatte 1 angeordnet und wird über Leiterbahnen 4 elektrisch leitend verbunden. Dabei sind die Leiterbahnen 4 über Seitenflächen der Trägerplatte 1 auf die Montageseite 101 der Vorrichtung geführt. Insbesondere weist die Trägerplatte 1 keine Durchbrüche zur elektrischen Kontaktierung des elektrischen Bauelements 2 auf.

Das elektrische Bauelement 2 ist von einem Gehäuse 3 vollständig umschlossen, wobei das Gehäuse 3 zur elektrischen Kontaktierung des elektrischen Bauelements 2 eine Befestigungsseite 103 der Trägerplatte 1 nicht vollständig überdeckt. Insbesondere weist die Trägerplatte 1 Bereiche auf, auf denen kein Gehäuse 3 angeordnet ist. Die Grundfläche des Gehäuses 3 ist demnach kleiner als die Grundfläche der Trägerplatte 1.

Die Trägerplatte 1 ragt somit an zwei gegenüberliegenden Seiten über das Gehäuse 3 hinaus. Mittels der überragenden Bereiche der Trägerplatte 1 wird die Befestigungsseite 103 und die Montageseite 101 der Trägerplatte 1 elektrisch leitend miteinander verbunden, insbesondere die Leiterbahnen 4 geführt.

Mit der Montageseite 101 kann die Vorrichtung auf einer Leiterplatte angeordnet sein (nicht dargestellt), wobei zur elektrischen Kontaktierung des elektrischen Bauelements 2 die Leiterbahnen der Trägerplatte 1 mit Anschlussstellen der Leiterplatte elektrisch leitend verbunden sind.

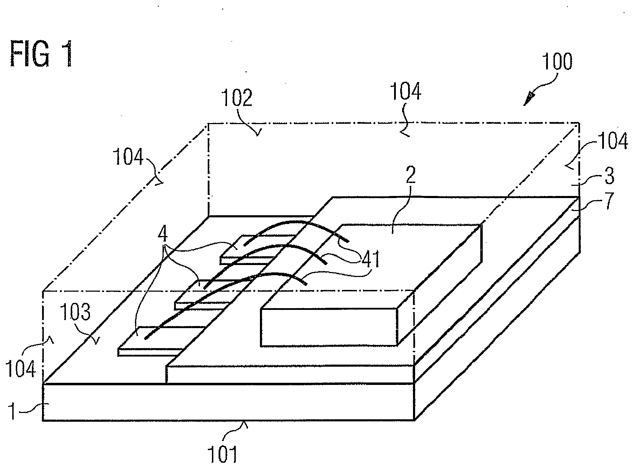

Durch die überragenden Bereiche der Trägerplatte 1 ist nachteilig ein großer Platzbedarf der Vorrichtung notwendig. Insbesondere weist die Grundfläche einer herkömmlichen Vorrichtung durch die überragenden Bereiche der Trägerplatte 1 eine weitaus größere Grundfläche auf als eine erfindungsgemäße Vorrichtung, wie sie beispielsweise in dem Ausführungsbeispiel der Figur 1 dargestellt ist.

In Figur 1 ist eine oberflächenmontierbare Vorrichtung 100 gezeigt, die eine Trägerplatte 1, ein elektrisches Bauelement 2 und ein Gehäuse 3 aufweist.

Bei dem elektrischen Bauelement 2 handelt es sich vorzugsweise um ein strahlungsemittierendes oder strahlungsdetektierendes Bauelement. Bevorzugt ist das Bauelement eine LED, eine IRED, ein Fototransistor, eine Fotodiode oder ein Opto-IC.

Das elektrische Bauelement 2 weist vorzugsweise eine zur Erzeugung oder zur Detektion von elektromagnetischer Strahlung geeignete aktive Schicht auf. Das Bauelement 2 ist bevorzugt in Dünnfilmbauweise ausgeführt. Insbesondere umfasst das Bauelement 2 bevorzugt epitaktisch abgeschiedene Schichten, die das Bauelement 2 bilden. Die Schichten des Bauelements 2 basieren bevorzugt auf einem III/V-Verbindungshalbleitermaterial.

Das Bauelement 2 weist bevorzugt eine Strahlungsaustrittsseite auf, an der die in der aktiven Schicht erzeugte Strahlung aus dem Bauelement 2 austritt. Die Strahlungsaustrittsseite des Bauelements ist vorzugsweise an der von der Trägerplatte gegenüberliegenden Seite angeordnet.

Insbesondere ist das Bauelement 2 auf einer Befestigungsseite 103 der Trägerplatte 1 angeordnet und von dem Gehäuse 3 vollständig umschlossen.

Die oberflächenmontierbare Vorrichtung 100 weist eine Montageseite 101 und eine Oberseite 102 auf. Die Trägerplatte 1 schließt die Vorrichtung 100 zur Montageseite 101 hin ab. Die Befestigungsseite 103 der Trägerplatte 1 ist gegenüberliegend der Montageseite 101 angeordnet.

Zur elektrischen Kontaktierung des Bauelements 2 sind auf der Befestigungsseite 103 der Trägerplatte 1 Leiterbahnen 4 angeordnet. Ferner sind auf der Montageseite 101 Kontaktflächen angeordnet (nicht dargestellt). Die Trägerplatte 1 weist ferner Durchbrüche auf, wobei jeweils eine Kontaktfläche mittels eines Durchbruchs mit einer Leiterbahn 4 elektrisch leitend verbunden ist. In dem Ausführungsbeispiel der Figur 1 sind insbesondere drei Durchbrüche unterhalb des Bauelements 2 angeordnet (nicht dargestellt).

Das Gehäuse 3 ist auf der Befestigungsseite 103 der Trägerplatte 1 angeordnet. Das Gehäuse 3 schließt die Vorrichtung 100 zur Oberseite 102 hin ab. Ferner sind das Gehäuse 3 und die Trägerplatte 1 in Draufsicht auf die Trägerplatte 1 bündig zueinander angeordnet.

Mit der Montageseite 101 kann die Vorrichtung 100 auf einer Leiterplatte angeordnet sein (nicht dargestellt). Insbesondere können zur elektrischen Kontaktierung des Bauelements 2 die Kontaktflächen der Trägerplatte 1 mit Anschlussstellen der Leiterplatte elektrisch leitend verbunden sein.

Dadurch, dass die Durchbrüche zumindest teilweise unterhalb des Bauelements 2 angeordnet sind, kann eine Platz sparende Vorrichtung erzielt werden. Insbesondere sind keine überragenden Trägerplattenbereiche, wie es herkömmlicherweise der Fall ist, nötig, um eine elektrische Kontaktführung zur Montageseite 101 der Vorrichtung 100 zu ermöglichen. Eine oberflächenmontierbare Vorrichtung 100 mit einer geringen Vorrichtungsgröße, insbesondere einer geringen lateralen Ausdehnung, ermöglicht sich so mit Vorteil.

Das Gehäuse 3 ist vorzugsweise für die von dem Bauelement 2 emittierte oder zu detektierende Strahlung transparent. Alternativ kann das Gehäuse 3 für Strahlung in einem erwünschten Wellenlängenbereich strahlungsundurchlässig sein. In diesem Fall erfüllt das Gehäuse 3 eine Filterfunktion für vorgegebene Wellenlängenbereiche.

Zwischen der Trägerplatte 1 und dem Bauelement 2 ist eine elektrisch isolierende Trennschicht 7 angeordnet. Die elektrisch isolierende Trennschicht 7 deckt die Durchbrüche, die in der Trägerplatte 1 angeordnet sind, vollständig ab. Ferner isoliert die Trennschicht 7 das Bauelement 2 und die Trägerplatte 1 voneinander. Die Trennschicht 7 ist bereichsweise auf den Leiterbahnen 4 der Trägerplatte 1 angeordnet. Die nicht von der Trennschicht 7 bedeckten Bereiche der Leiterbahnen 4 sind jeweils mit einem Bonddraht 41 mit einer Oberseite des Bauelements 2 elektrisch leitend verbunden.

In dem Ausführungsbeispiel der Figur 1 ist das elektrische Bauelement 2 somit lediglich an der Oberseite elektrisch leitend kontaktiert. Die Unterseite des Bauelements 2 dagegen ist durch die Trennschicht 7 elektrisch von den Leiterbahnen 4 isoliert.

Das Gehäuse 3 weist vorzugsweise ein elektrisch isolierendes Material auf. Bevorzugt isoliert das Gehäuse 3 das Bauelement 2, die Leiterbahnen 4 und die Bonddrähte 41 nach außen hin vollständig. Insbesondere ist die Vorrichtung 100 ausschließlich über die Montageseite 101 nach außen hin elektrisch leitend kontaktierbar. Insbesondere ist die Vorrichtung 100 ausschließlich mittels der in der Trägerplatte 1 angeordneten Durchbrüche elektrisch leitend kontaktierbar.

Die Vorrichtung 100 weist vorzugsweise Seitenflächen 104 auf, wobei die Seitenflächen 104 und die Oberseite 102 nach außen hin vollständig elektrisch isolierend ausgebildet sind. Insbesondere sind keine elektrischen Verbindungen, insbesondere Leiterbahnen 4 und/oder Bonddrähte, von dem Bauelement 2 an eine der Seitenflächen 104 geführt. Dadurch ist es möglich, dass an dem Gehäuse 3 der Vorrichtung 100, insbesondere neben oder auf der Vorrichtung 100, weitere elektrische Bauelemente 2 oder Vorrichtungen 100 angeordnet sein können, ohne dabei einen Kurzschluss zu erzeugen. So können eine Mehrzahl von Vorrichtungen 100 und/oder elektrischen Bauelementen 2 Platz sparend nebeneinander angeordnet sein, ohne dass sich die elektrischen Führungen der Vorrichtungen 100 beziehungsweise Bauelemente 2 überschneiden.

In dem Ausführungsbeispiel der Figur 1 ist das elektrische Bauelement 2 über drei Bonddrähte 41 jeweils mit einer Leiterbahn 4 elektrisch leitend verbunden. Alternativ kann das Bauelement 2 auch von der Unterseite her über einen Durchbruch der Trägerplatte 1 elektrisch leitend verbunden sein. Dazu ist in der Trennschicht 7 mindestens eine Öffnung vorgesehen, die ein elektrisch leitendes Material, beispielsweise ein Metall oder eine Metalllegierung, enthält. Dadurch kann zumindest ein Durchbruch der Trägerplatte 1 mittels der Öffnung der Trennschicht 7 mit der Unterseite des Bauelements 2 elektrisch leitend verbunden sein.

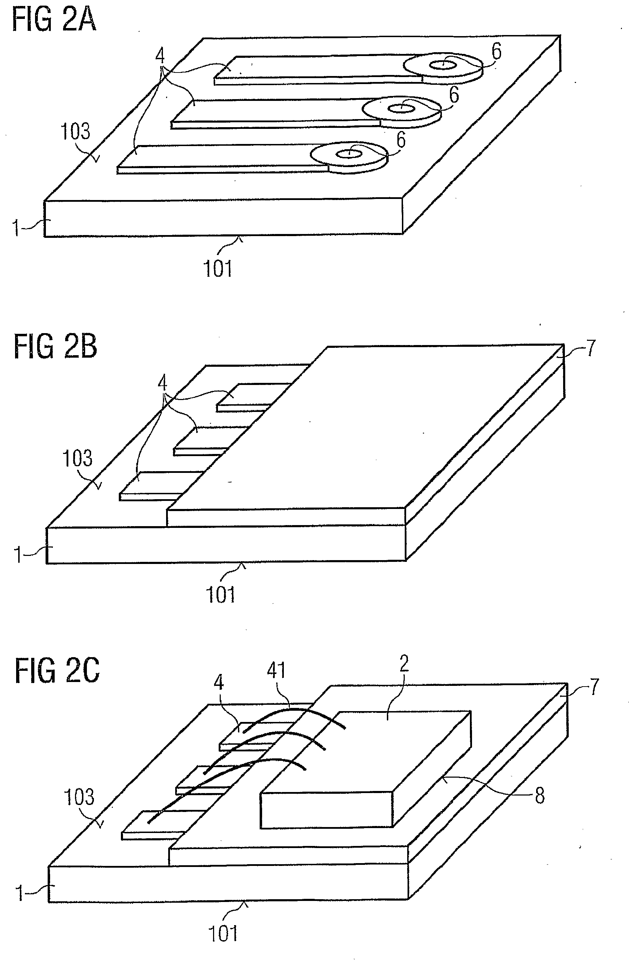

In den Figuren 2A bis 2C ist jeweils eine schematische Ansicht einer erfindungsgemäßen Vorrichtung in verschiedenen Herstellungsstadien dargestellt. Figur 2A zeigt die Trägerplatte 1 in einer Aufsicht.

Die Trägerplatte 1 weist eine Montageseite 101 und eine Befestigungsseite 103 auf. Auf der Befestigungsseite 103 sind Leiterbahnen 4 ausgebildet. Ferner sind in der Trägerplatte 1 Durchbrüche 6 ausgebildet. Die Durchbrüche 6 sind mit einem elektrisch leitendem Material, beispielsweise einem Metall oder einer Metalllegierung, gefüllt. Ferner sind die Durchbrüche 6 jeweils unterhalb eines Endbereichs jeweils einer Leiterbahn 4 angeordnet. Das innerhalb der Durchbrüche 6 angeordnete elektrisch leitende Material kann so direkt elektrisch leitend jeweils mit einem Endbereich der Leiterbahnen 4 verbunden sein.

Auf der Montageseite 101 der Trägerplatte 1 sind Kontaktflächen angeordnet (nicht dargestellt). Die Kontaktflächen sind jeweils über die Durchbrüche 6 mit jeweils einer Leiterbahn 4 elektrisch leitend verbunden. Insbesondere ist das elektrisch leitende Material jeweils in den Durchbrüchen 6 mit einer Leiterbahn 4 und mit einer Kontaktfläche elektrisch leitend verbunden, sodass jeweils eine Leiterbahn 4 der Befestigungsseite 103 mit einer Kontaktfläche der Montageseite 101 elektrisch leitend verbunden ist.

Figur 2B weist einen nächsten Verfahrensschritt bei der Herstellung einer oberflächenmontierbaren Vorrichtung auf. Auf Teilbereichen der Trägerplatte 1 ist eine elektrisch isolierende Trennschicht 7 angeordnet. Insbesondere sind die Durchbrüche der Trägerplatte 1 an der Befestigungsseite 103 mittels der Trennschicht 7 abgedeckt.

Die Leiterbahnen 4 der Trägerplatte 1 sind zum Teil von der Trennschicht 7 überdeckt. Eine in diesem Verfahrensstadium hergestellte oberflächenmontierbare Vorrichtung kann demnach in zwei Teilbereiche eingeteilt werden. Insbesondere weist die Vorrichtung einen Teilbereich auf, der an der Befestigungsseite 103 der Trägerplatte 1 mittels der Trennschicht 7 elektrisch isolierend ausgebildet ist. Ferner weist die Vorrichtung einen zweiten Teilbereich auf, bei dem die Befestigungsseite 103 Leiterbahnen 4 aufweist, die nicht mit einer elektrisch isolierenden Trennschicht 7 versehen sind. In diesem Teilbereich kann die Vorrichtung somit über die Leiterbahnen 4, die Durchbrüche und die Kontaktflächen elektrisch leitend kontaktiert sein.

In der in Figur 2C dargestellten Vorrichtung ist auf die elektrisch isolierende Trennschicht 7 ein elektrisches Bauelement 2 aufgebracht. Hierbei ist das elektrische Bauelement 2 mittels eines Klebers 8 oder eines Lotes auf der Trennschicht 7 befestigt.

Das elektrische Bauelement 2 ist, ebenso wie in dem in Figur 1 dargestellten Ausführungsbeispiel, vorzugsweise ein strahlungsemittierendes oder detektierendes Bauelement. Insbesondere ist das Bauelement bevorzugt eine LED, eine IRED, ein Fototransistor, eine Fotodiode oder ein Opto-IC. Zur elektrischen Kontaktierung des Bauelements 2 ist jeweils von einer Leiterbahn 4 ein Bonddraht 41 zu einer Kontaktstelle an einer Oberseite des Bauelements 2, die der Trägerplatte 1 gegenüberliegt, geführt.

In einem nächsten Verfahrensschritt wird ein Gehäuse auf der Befestigungsseite 103 der Trägerplatte 1 angeordnet (nicht dargestellt). Insbesondere ist das Gehäuse so angeordnet, dass das elektrische Bauelement 2, die Bonddrähte 41 und die Leiterbahnen 4 vollständig von dem Gehäusematerial umschlossen sind. Die Oberseite und die Seitenflächen der Vorrichtung sind so vollständig elektrisch isolierend ausgebildet. Eine elektrische Kontaktierung der Vorrichtung ist demnach lediglich über die Montageseite 101 möglich. Insbesondere versiegelt das Gehäuse das Bauelement 2 und die Bonddrähte 41 (nicht dargestellt). Das Aufbringen des Gehäuses erfolgt bevorzugt mittels eines Transfermoldprozesses. Das Gehäuse weist vorzugsweise eine Moldmasse auf, die für Strahlung transparent ist oder eine Filterwirkung für bestimmte Wellenlängenbereiche aufweist. Nach Aufbringen des Gehäuses ist eine Vorrichtung, wie sie beispielsweise in dem Ausführungsbeispiel der Figur 1 gezeigt ist, erzeugt.

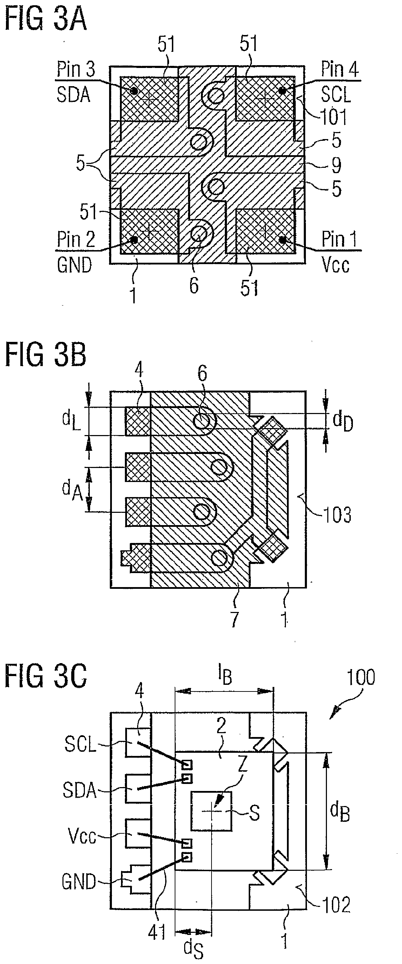

In den Figuren 3A bis 3c ist jeweils eine Aufsicht auf ein weiteres Ausführungsbeispiel einer erfindungsgemäßen Vorrichtung gezeigt. Insbesondere ist in Figur 3A eine Aufsicht auf eine Montageseite 101 der Vorrichtung dargestellt. Figur 3B zeigt eine Aufsicht auf eine Befestigungsseite 103 der Trägerplatte 1. In Figur 3C ist eine schematische Aufsicht auf eine Oberseite 102 einer oberflächenmontierbaren Vorrichtung 100 schematisch dargestellt.

An der Montageseite 101 der Trägerplatte 1 sind Kontaktflächen 5 angeordnet. In dem Ausführungsbeispiel der Figur 3A sind vier.durch einen Abstand voneinander elektrisch isolierte Kontaktflächen 5 angeordnet. Die Kontaktflächen 5 überschneiden sich zumindest teilweise mit in der Trägerplatte 1 integrierten Durchbrüchen 6. Jeweils eine Kontaktfläche 5 ist unterhalb eines Durchbruchs 6 angeordnet. Die Durchbrüche 6 sind vorzugsweise mit einem elektrisch leitenden Material, beispielsweise einem Metall oder einer Metalllegierung gefüllt. So können die Kontaktflächen 5, die an der Unterseite der Trägerplatte 1 angeordnet sind, mit Leiterbahnen an der Befestigungsseite der Trägerplatte 1 elektrisch leitend verbunden sein.

Die Kontaktflächen 5 und die Abstände zwischen den Kontaktflächen 5 sind bevorzugt teilweise mit einem elektrisch isolierenden Material 9 planarisiert. Insbesondere sind die Bereiche zwischen den Kontaktflächen 5 vollständig mit einem elektrisch isolierenden Material 9 gefüllt. Die Kontaktflächen 5 sind bevorzugt lediglich teilweise, insbesondere in Bereichen der Durchbrüche 6, mit dem elektrisch isolierenden Material 9 versehen. Teilbereiche der Kontaktflächen 5 weisen vorzugsweise kein elektrisch isolierendes Material 9 auf, sodass in den Teilbereichen externe elektrische Anschlussstellen 51 erzeugt sind. In dem Ausführungsbeispiel der Figur 3A sind vier voneinander isolierte elektrische Anschlussstellen 51 angeordnet.

Die Anschlussstellen 51 sind jeweils vorzugsweise zu einer externen Kontaktierung vorgesehen. Beispielsweise ist eine elektrische Anschlussstelle 51 als Masseanschluss (Ground: GND) vorgesehen. Eine weitere elektrische Anschlussstelle kann beispielsweise als Anschlussstelle für eine Versorgungsspannung (voltage of the common collector: VCC) vorgesehen sein. Eine weitere Anschlussstelle ist beispielsweise für eine SCL (single computer logic) vorgesehen. Die in dem Ausführungsbeispiel der Figur 3A letzte Anschlussstelle kann beispielsweise als Anschlussstelle für ein SDA (smart digital assistant) Anwendung finden.

Die Kontaktflächen 51 weisen bevorzugt eine Länge in einem Bereich zwischen 0,5 mm und 0,7 mm, insbesondere 0,6 mm, auf. Die Breite der Kontaktflächen 51 liegt jeweils etwa in einem Bereich zwischen 0,4 mm und 0,5 mm und beträgt insbesondere vorzugsweise 0,45 mm.

Die Kontaktflächen 51 weisen jeweils einen Mittelpunkt auf, der in der Figur 3A durch ein Kreuz gekennzeichnet ist. Die Mittelpunkte zweier Kontaktflächen 51 sind beispielsweise in einem Abstand zueinander zwischen 1,1 mm und 1,4 mm angeordnet.

In Figur 3B ist eine Aufsicht auf eine Befestigungsseite 103 einer Trägerplatte 1 gezeigt. Ein elektrisches Bauelement und ein Gehäuse sind in dem Ausführungsbeispiel der Figur 3B der Übersicht halber nicht dargestellt.

Auf der Befestigungsseite 103 der Trägerplatte 1 sind Leiterbahnen 4 angeordnet. Bevorzugt weisen die Leiterbahnen 4 eine Breite d_{L} in einem Bereich zwischen 0,2 mm und 0,4 mm und einen Abstand zueinander d_{A} in einem Bereich zwischen 0,4 mm und 0,5 mm auf. Beispielsweise weisen die Leiterbahnen 4 eine Breite d_{L} von 0,3 mm und einen Abstand zueinander d_{A} von 0,467 mm auf.

Unterhalb eines Teilbereichs der Leiterbahnen 4 ist jeweils ein Durchbruch 6 der Trägerplatte 1 angeordnet. Die Leiterbahnen 4 umschließen bevorzugt vollständig den Durchbruch 6. Ein in dem Durchbruch 6 angeordnetes elektrisch leitendes Material kann so mit jeweils einer Leiterbahn 4 elektrisch leitend verbunden sein. Die Durchbrüche 6 weisen jeweils beispielsweise einen Durchmesser d_{D} von etwa 0,15 mm auf.

Auf zumindest einem Teilbereich der Befestigungsseite 103 der Trägerplatte 1 ist eine elektrisch isolierende Trennschicht 7 angeordnet. Insbesondere sind die Durchbrüche 6 der Trägerplatte 1 und ein Teilbereich der Leiterbahnen 4 von der elektrisch isolierenden Trennschicht 7 abgedeckt. Weitere Teilbereiche der Leiterbahnen 4 dagegen weisen keine elektrisch isolierende Trennschicht 7 auf. In diesen weiteren Teilbereichen kann ein elektrisches Bauelement mittels beispielsweise Bonddrähten mit den Leiterbahnen 4 elektrisch leitend verbunden sein.

In Figur 3C ist eine Aufsicht auf eine oberflächenmontierbare Vorrichtung dargestellt. Im Vergleich zu dem Ausführungsbeispiel der Figur 3B ist auf der elektrisch isolierenden Schicht 7 ein elektrisches Bauelement 2, insbesondere eine LED, eine IRED, ein Fototransistor, eine Fotodiode oder ein Opto-IC, angeordnet. Das elektrische Bauelement 2 weist beispielsweise eine Breite d_{B} von etwa 1,2 mm und eine Länge l_{B} von etwa 1 mm auf. Ferner weist das elektrische Bauelement 2 vorzugsweise einen strahlungsemittierenden Bereich S auf, der einen Zentralbereich Z aufweist. Der Zentralbereich Z ist beispielsweise zu einer Seitenfläche des elektrischen Bauelements 2 in einem Abstand von etwa 0,35 mm angeordnet.

Der strahlungsemittierende Bereich S weist beispielsweise eine Fläche von etwa 0,16 mm² auf.

Kontaktstellen des elektrischen Bauelements 2 sind vorzugsweise jeweils mittels eines Bonddrahtes 41 mit einer Leiterbahn 4 elektrisch leitend verbunden. Insbesondere sind die Bonddrähte 41 jeweils mit einem Teilbereich der Trägerplatte 4 elektrisch leitend verbunden, auf dem keine elektrisch isolierende Trennschicht 7 angeordnet ist.

Das elektrische Bauelement 2 ist bevorzugt auf der elektrisch isolierenden Schicht 7 angeordnet. Dadurch werden die Leiterbahnen 4 von dem elektrischen Bauelement 2 in einem Befestigungsbereich des Bauelements 2 elektrisch isoliert. Ein Kurzschluss des Bauelements 2 kann so vermieden werden.

Die Vorrichtung weist beispielsweise eine Grundfläche von etwa 2 +/- 0,15 mm² auf.

In Figur 4 ist ein Querschnitt einer oberflächenmontierbaren Vorrichtung 100, beispielsweise einer Vorrichtung 100 des Ausführungsbeispiels aus Figur 1, dargestellt. Auf einer Befestigungsseite 103 einer Trägerplatte 1 ist eine elektrisch isolierende Trennschicht 7 und darauf ein elektrisches Bauelement 2 angeordnet. Die Trägerplatte 1 weist Durchbrüche 6 auf, durch die elektrische Führungen, insbesondere elektrisch leitendes Material, zu Kontaktflächen 5, die auf einer Montageseite 101 der Vorrichtung angeordnet sind, führen. Das elektrische Bauelement 2 kann so mittels der Durchbrüche 6 an der Montageseite 101 der Vorrichtung 100 extern elektrisch kontaktiert sein. Insbesondere ist die Vorrichtung 100 lediglich von der Montageseite 101 elektrisch kontaktierbar.

Das elektrische Bauelement 2 weist beispielsweise eine Höhe d_{H} von etwa 0,22 mm auf. Die Vorrichtung 100 weist beispielsweise eine Höhe d_{V} von etwa 0,7 +/- 0,1 mm auf.

Das elektrische Bauelement 2 ist vollständig von einem Gehäuse 3 umformt, insbesondere umschlossen. Ferner sind die Bonddrähte 41 vollständig von dem Gehäuse 3 umschlossen. Das Gehäuse 3 ist insbesondere bündig mit der Trägerplatte 1 angeordnet. Insbesondere gehen die Seitenflächen des Gehäuses 3 linear in die Seitenflächen der Trägerplatte 1 über.

Auf der Montageseite 101 der Vorrichtung 100 sind Kontaktflächen 5, insbesondere externe Anschlussstellen 51 und ein elektrisch isolierendes Material 9 angeordnet. Durch das elektrisch isolierende Material 9 kann mit Vorteil die Vorrichtung 100 zur Montageseite 101 planarisiert sein. Ferner können so mit Vorteil Kurzschlüsse der Vorrichtung 100 und/oder des elektrischen Bauelements 2 vermieden werden. Durch die Anschlussstellen 51 kann die Vorrichtung nach außen hin elektrisch kontaktiert sein.

Die Erläuterung der erfindungsgemäßen Vorrichtung anhand der oben beschriebenen Ausführungsbeispiele ist nicht als Beschränkung der Erfindung auf diese zu betrachten. Vielmehr ist die Erfindung definiert durch die nachfolgenden Ansprüche.

## Patentansprüche

1. Oberflächenmontierbare Vorrichtung (100), die eine Montageseite (101), eine der Montageseite (101) gegenüberliegende Oberseite (102), eine elektrisch isolierende Trägerplatte (1), ein elektrisches Bauelement (2) und ein Gehäuse (3) aufweist, wobei
- die Trägerplatte (1) die Vorrichtung (100) zur Montageseite (101) hin abschließt, eine der Montageseite (101) gegenüberliegende Befestigungsseite (103) aufweist, zur elektrischen Kontaktierung des Bauelements (2) auf der Befestigungsseite (103) angeordnete Leiterbahnen (4), auf der Montageseite (101) angeordnete Kontaktflächen (5) und Durchbrüche (6) aufweist, wobei
jeweils eine Kontaktfläche (5) mittels eines Durchbruchs (6) mit einer Leiterbahn (4) elektrisch leitend verbunden ist,
- das Bauelement (2) auf der Befestigungsseite (103) der Trägerplatte (1) angeordnet und von dem Gehäuse (3) umschlossen ist, wobei zumindest ein Durchbruch (6) unterhalb des Bauelements (2) angeordnet ist,
- das Gehäuse (3) auf der Befestigungsseite (103) der Trägerplatte (1) angeordnet ist, sodass das Gehäuse (3) und die Trägerplatte (1) in Draufsicht auf die Trägerplatte (1) bündig zueinander angeordnet sind, und das Gehäuse (3) die Vorrichtung (100) zur Oberseite (102) hin abschließt,
- das Bauelement (2) eine zur Erzeugung oder zur Detektion von elektromagnetischer Strahlung geeignete aktive Schicht aufweist,
**dadurch gekennzeichnet, dass**
- zwischen dem Bauelement (2) und der Trägerplatte (1) eine elektrisch isolierende Trennschicht (7) angeordnet ist, wobei das elektrische Bauelement (2) mittels eines Klebers (8) oder eines Lotes auf der Trennschicht (7) befestigt ist,
- in der Trennschicht (7) mindestens eine Öffnung angeordnet ist, und
- die Öffnung ein elektrisch leitendes Material enthält, sodass zumindest ein Durchbruch der Trägerplatte (1) mittels der Öffnung der Trennschicht mit dem Bauelement (2) elektrisch leitend verbunden ist.

2. Oberflächenmontierbare Vorrichtung gemäß Anspruch 1, wobei
die Durchbrüche (6) ausschließlich unterhalb des Bauelements (2) angeordnet sind.

3. Oberflächenmontierbare Vorrichtung gemäß einem der vorhergehenden Ansprüche, wobei
das Gehäuse (3) das Bauelement (2) und die Leiterbahnen nach außen hin vollständig elektrisch isoliert.

4. Oberflächenmontierbare Vorrichtung gemäß einem der vorhergehenden Ansprüche, wobei
die Vorrichtung (100) ausschließlich über die Montageseite (101) nach außen hin elektrisch leitend kontaktierbar ist.

5. Oberflächenmontierbare Vorrichtung gemäß einem der vorhergehenden Ansprüche, wobei
die Vorrichtung (100) ausschließlich mittels der Durchbrüche (6) elektrisch leitend kontaktierbar ist.

6. Oberflächenmontierbare Vorrichtung gemäß einem der vorhergehenden Ansprüche, wobei
die Vorrichtung (100) Seitenflächen (104) aufweist, und die Seitenflächen (104) und die Oberseite (102) nach außen hin vollständig elektrisch isolierend ausgebildet sind.

7. Oberflächenmontierbare Vorrichtung gemäß einem der vorhergehenden Ansprüche, wobei
die auf der Befestigungsseite der Trägerplatte angeordneten Leiterbahnen (4) teilweise mit der elektrisch isolierenden Trennschicht (7) bedeckt sind.

8. Oberflächenmontierbare Vorrichtung gemäß einem der vorhergehenden Ansprüche, wobei
das Bauelement (2) auf einem Durchbruch (6) der Trägerplatte (1) angeordnet und durch den Durchbruch (6) mit einer Kontaktfläche (5) elektrisch leitend verbunden ist.

9. Oberflächenmontierbare Vorrichtung gemäß einem der vorhergehenden Ansprüche, wobei
das Bauelement (2) eine LED, eine IRED, ein Phototransistor, eine Photodiode oder ein Opto-IC ist.

10. Oberflächenmontierbare Vorrichtung gemäß einem der vorhergehenden Ansprüche, wobei
das Gehäuse (3) für Strahlung in einem Wellenlängenbereich strahlungsundurchlässig ist.

11. Oberflächenmontierbare Vorrichtung gemäß einem der vorhergehenden Ansprüche, wobei
eine Mehrzahl elektrischer Bauelemente (2) auf der Befestigungsseite (103) der Trägerplatte (1) angeordnet ist, die jeweils von dem Gehäuse (3) umschlossen sind.

12. Oberflächenmontierbare Vorrichtung gemäß einem der vorhergehenden Ansprüche, wobei
die Trägerplatte (1) einen mehrschichtigen Aufbau aufweist.

13. Oberflächenmontierbare Vorrichtung gemäß einem der vorhergehenden Ansprüche, wobei
die Durchbrüche einen elektrisch leitenden Vollkörper enthalten, der in die Durchbrüche eingesteckt ist.

14. Oberflächenmontierbare Vorrichtung gemäß Anspruch 13, wobei
der Vollkörper den Durchbruch vollständig ausfüllt.

15. Oberflächenmontierbare Vorrichtung gemäß einem der vorhergehenden Ansprüche, wobei
- das Gehäuse als Filter für die von dem Bauelement (2) emittierte oder zu detektierende Strahlung ausgebildet ist, und
- das Gehäuse für Strahlung in einem unerwünschten Wellenlängenbereich strahlungsundurchlässig ausgebildet ist, sodass der unerwünschte Wellenlängenbereich aus einem Wellenlängenbereich der von dem Bauelement emittierten oder zu detektierenden Strahlung selektiv herausgefiltert ist.

## Claims

1. A surface-mountable device (100) comprising a mounting side (101), a top side (102) lying opposite the mounting side (101), an electrically insulating carrier plate (1), an electrical component (2) and a housing (3),
wherein
- the carrier plate (1) terminates the device (100) toward the mounting side (101), has a fixing side (103) lying opposite the mounting side (101), conductor tracks (4) arranged on the fixing side (103) for the purpose of making electrical contact with the component (2), contact areas (5) arranged on the mounting side (101), and through-vias (6), wherein in each case a contact area (5) is electrically conductively connected to a conductor track (4) by means of an through-via (6),
- the component (2) is arranged on the fixing side (103) of the carrier plate (1) and is enclosed by the housing (3), wherein at least one through-via (6) is arranged below the component (2),
- the housing (3) is arranged on the fixing side (103) of the carrier plate (1), such that the housing (3) and the carrier plate (1) are arranged flush with one another in a plan view of the carrier plate (1), and the housing (3) terminates the device (100) toward the top side (102),
- the component (2) has an active layer suitable for generating or for detecting electromagnetic radiation,
**characterized in that**
- an electrically insulating separating layer (7) is arranged between the component (2) and the carrier plate (1), wherein the electrical component (2) is fixed on the separating layer (7) by an adhesive (8) or a solder,
- at least one opening is arranged in the separating layer (7), and
- the opening contains an electrically conductive material such that at least one through-via of the carrier plate (1) is electrically conductively connected to the component (2) through the opening.

2. The surface-mountable device according to claim 1,
wherein
the through-vias (6) are arranged exclusively below the component (2).

3. The surface-mountable device according to either of the preceding claims, wherein
the housing (3) completely electrically insulates the component (2) and the conductor tracks toward the outside.

4. The surface-mountable device according to any of the preceding claims, wherein
the device (100) is electrically conductively contact-connectable toward the outside exclusively via the mounting side (101).

5. The surface-mountable device according to any of the preceding claims, wherein
the device (100) is electrically conductively contact-connectable exclusively by means of the through-vias (6).

6. The surface-mountable device according to any of the preceding claims, wherein
the device (100) has side areas (104), and the side areas (104) and the top side (102) are embodied as completely electrically insulating toward the outside.

7. The surface-mountable device according to any of the preceding claims, wherein
the conductor tracks (4) arranged on the fixing side of the carrier plate are partially covered by the electrically insulating separating layer (7).

8. The surface-mountable device according to any of the preceding claims, wherein
the component (2) is arranged on an through-via (6) of the carrier plate (1) and is electrically conductively connected to a contact area (5) through the through-via (6).

9. The surface-mountable device according to any of the preceding claims, wherein
the component (2) is an LED, an IRED, a phototransistor, a photodiode or an opto-IC.

10. The surface-mountable device according to any of the preceding claims, wherein
the housing (3) is radiation-opaque to radiation in a wavelength range.

11. The surface-mountable device according to any of the preceding claims, wherein
a plurality of electrical components (2) are arranged on the fixing side (103) of the carrier plate (1), said components in each case being enclosed by the housing (3).

12. The surface-mountable device according to any of the preceding claims, wherein
the carrier plate (1) has a multilayered construction.

13. The surface-mountable device according to any of the preceding claims, wherein
the through-vias comprise a solid body that is inserted into the through-vias.

14. The surface-mountable device according to any of the preceding claims, wherein
the solid body completely fills the through-via.

15. The surface-mountable device according to any of the preceding claims, wherein
- the housing (3) is formed as a filter for the radiation emitted or to be detected by the component (2), and
- the housing is formed to be radiation-opaque to radiation in a undesired wavelength range so that the undesired wavelength range is filtered out selectively from the wavelength range of the radiation emitted or to be detected by the component.

## Revendications

1. Dispositif (100) pouvant être monté en surface, lequel présente un côté de montage (101), un côté supérieur (102) opposé au côté de montage (101), une plaque de support (1) électriquement isolante, un composant électrique (2) et un boîtier (3),
- la plaque de support (1) terminant le dispositif (100) en direction du côté de montage (101), présentant un côté de fixation (103) opposé au côté de montage (101), présentant des pistes (4) disposées sur le côté de fixation (103) pour la mise en contact électrique du composant (2), présentant des surfaces de contact (5) et des passages (6), disposés sur le côté de montage (101), respectivement une surface de contact (5) étant reliée de manière électro-conductrice à une piste (4) au moyen d'un passage (6),
- le composant (2) étant disposé sur le côté de fixation (103) de la plaque de support (1) et étant entouré par le boîtier (3), au moins un passage (6) étant disposé en dessous du composant (2),
- le boîtier (3) étant disposé sur le côté de fixation (103) de la plaque de support (1), de sorte que le boîtier (3) et la plaque de support (1), en vue de dessus sur la plaque de support (1), sont disposés de manière affleurée l'un par rapport à l'autre, et le boîtier (3) terminant le dispositif (100) en direction du côté supérieur (102),
- le composant (2) présentant une couche active appropriée à générer ou détecter un rayonnement électromagnétique,
**caractérisé en ce qu'**
- une couche de séparation (7) électriquement isolante est disposée entre le composant (2) et la plaque de support (1), le composant (2) électrique étant fixé sur la couche de séparation (7) au moyen d'une colle (8) ou d'un alliage de soudure,
- au moins une ouverture étant disposée dans la couche de séparation (7), et
- l'ouverture contenant une matière électro-conductrice, de sorte qu'au moins un passage de la plaque de support (1) est relié au composant (2) de manière électro-conductrice au moyen de l'ouverture de la couche de séparation.

2. Dispositif pouvant être monté en surface selon la revendication 1,
les passages (6) étant uniquement disposés en dessous du composant (2).

3. Dispositif pouvant être monté en surface selon l'une quelconque des revendications précédentes,
le boîtier (3) isolant électriquement le composant (2) et les pistes complètement vers l'extérieur.

4. Dispositif pouvant être monté en surface selon l'une quelconque des revendications précédentes,
le dispositif (100) pouvant être mis en contact de manière électro-conductrice vers l'extérieur uniquement par l'intermédiaire du côté de montage (101).

5. Dispositif pouvant être monté en surface selon l'une quelconque des revendications précédentes,
le dispositif (100) pouvant être mis en contact de manière électro-conductrice uniquement au moyen des passages (6).

6. Dispositif pouvant être monté en surface selon l'une quelconque des revendications précédentes,
le dispositif (100) présentant des surfaces latérales (104), et les surfaces latérales (104) et le côté supérieur (102) étant réalisés en isolant complètement électriquement vers l'extérieur.

7. Dispositif pouvant être monté en surface selon l'une quelconque des revendications précédentes,
les pistes (4) disposées sur le côté de fixation de la plaque de support étant recouvertes en partie par la couche de séparation (7) isolant électriquement.

8. Dispositif pouvant être monté en surface selon l'une quelconque des revendications précédentes,
le composant (2) étant disposé sur un passage (6) de la plaque de support (1) et étant relié de manière électro-conductrice à une surface de contact (5) à travers le passage (6).

9. Dispositif pouvant être monté en surface selon l'une quelconque des revendications précédentes,
le composant (2) étant une LED, une IRED, un phototransistor, une photodiode ou un optocoupleur.

10. Dispositif pouvant être monté en surface selon l'une quelconque des revendications précédentes,
le boîtier (3) étant imperméable au rayonnement pour le rayonnement dans une plage de longueur d'onde.

11. Dispositif pouvant être monté en surface selon l'une quelconque des revendications précédentes,
une pluralité de composants électriques (2) étant disposés sur le côté de fixation (103) de la plaque de support (1), lesquels sont respectivement entourés par le boîtier (3).

12. Dispositif pouvant être monté en surface selon l'une quelconque des revendications précédentes,
la plaque de support (1) présentant une structure multicouche.

13. Dispositif pouvant être monté en surface selon l'une quelconque des revendications précédentes,
les passages contenant un corps plein électro-conducteur qui est enfiché dans les passages.

14. Dispositif pouvant être monté en surface selon la revendication 13,
le corps plein remplissant entièrement le passage.

15. Dispositif pouvant être monté en surface selon l'une quelconque des revendications précédentes,
- le boîtier étant réalisé comme filtre pour le rayonnement émis par le composant (2) ou le rayonnement à détecter, et
- le boîtier étant réalisé de manière imperméable au rayonnement pour le rayonnement dans une plage de longueur d'onde non souhaitée, de sorte que la plage de longueur d'onde non souhaitée est sélectivement filtrée à partir d'une plage de longueur d'onde du rayonnement émis par le composant ou du rayonnement à détecter.
